Europäisches Patentamt

European Patent Office

Office européen des brevets

(11) Publication number: **0 164 892**
**B1**

(12) **EUROPEAN PATENT SPECIFICATION**

(45) Date of publication of patent specification: **18.01.89**

(51) Int. Cl.⁴: **H 01 L 21/324, H 01 L 21/68**

(21) Application number: **85303270.4**

(22) Date of filing: **09.05.85**

(54) Horizontal furnace apparatus.

(30) Priority: **15.05.84 JP 96983/84**

(43) Date of publication of application:
**18.12.85 Bulletin 85/51**

(45) Publication of the grant of the patent:
**18.01.89 Bulletin 89/03**

(84) Designated Contracting States:
**DE FR GB**

(56) References cited:
**DE-A-2 524 616**
**DE-A-2 848 691**
**GB-A-1 160 162**

**RGA REVIEW, vol. 44, June 1983, OLSEN et al.:
"Double-Barrel III-V compound vapour-phase
epitaxy systems", pages 270-286**

**JOURNAL OF VACUUM SCIENCE &
TECHNOLOGY, vol. 14, no. 5, Sept./Oct. 1977,
New York. KERN et al.: "Advances in
deposition processes for passivation films",
pages 1082-1099**

(73) Proprietor: **FUJITSU LIMITED**
**1015, Kamikodanaka Nakahara-ku**
**Kawasaki-shi Kanagawa 211 (JP)**

(72) Inventor: **Sakurai, Junji c/o FUJITSU LIMITED**
**Patent Department 1015 Kamikodanaka**
**Nakahara-ku Kawasaki-shi kanagawa 211 (JP)**

(74) Representative: **Sunderland, James Harry et al**
**HASELTINE LAKE & CO Hazlitt House 28**
**Southampton Buildings Chancery Lane**
**London WC2A 1AT (GB)**

Courier Press, Leamington Spa, England.

## Description

The present invention relates to horizontal furnace apparatus, for instance for processing semiconductor devices such as semiconductor integrated circuits (IC).

The fabrication of semiconductor devices, ICs for instance, involves a large number of physical and chemical processes, such as diffusion processes for the formation of doped diffusion regions in wafers, oxidation processes for the formation of oxide layers on wafers, chemical vapour deposition (CVD) processes for the formation of epitaxial layers, etc., including relevant heat treatments. Heat treatment temperatures may be rather high, in excess of 1000°C. The major furnace type employed currently in IC mass-production lines is a horizontal furnace type. In order to improve productivity and reliability of heat treatments, large heat-treatment capacity, uniform temperature distribution and dust-free cleanliness are indispensible requirements of a horizontal furnace. A vertical furnace type has been used recently, but is still in the minority.

Generally, a dust-free system is essential for the production of semiconductor devices. In this regard, with a horizontal furnace, there has been a problem of dust mainly comprising particulates generated by friction between quartz boats and a quartz furnace tube during loading and unloading of wafers into the furnace. The particulates are mainly of quartz, being derived from wear generated by the quartz-to-quartz friction between quartz-wares; boats and furnace tubes, etc. In addition, residual materials deposited on the inner wall of the quartz furnace tube during heat treatments for CVD processes, for instance, are scraped to create particulates of associated materials.

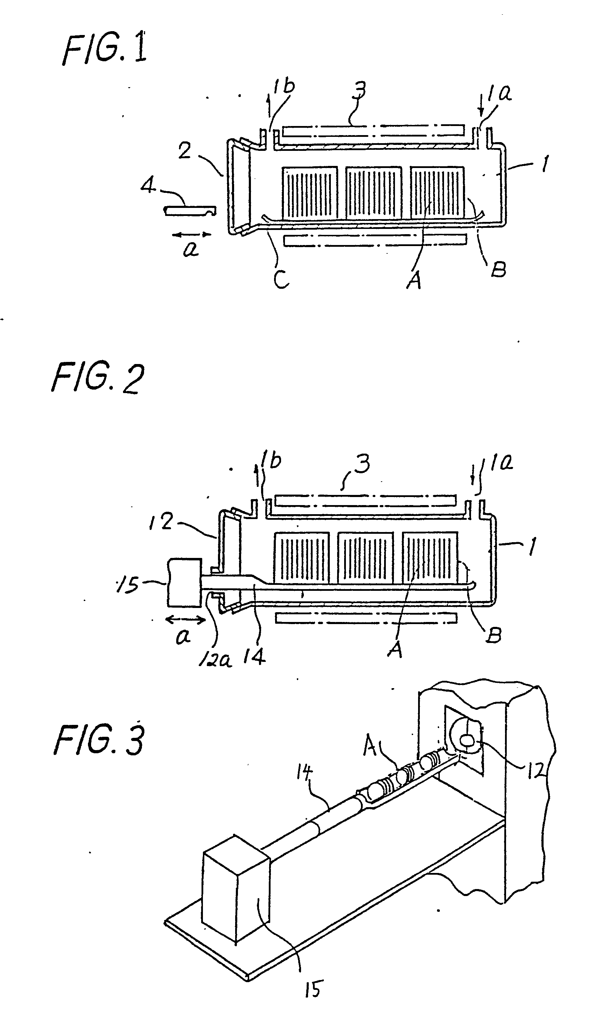

Fig. 1 is a cross-sectional view of a previously proposed horizontal furnace, schematically illustrating the structure of the furnace and aspects of loading of wafers to be heat treated. Wafers A are stacked in several quartz baskets B and accommodated on a quartz boat C. The wafers A are loaded into the furnace by pushing the boat C into furnace tube 1 in the direction of an arrow a, using a quartz bar 4 having a hooking notch at its end. Similarly, the wafers A are unloaded by pulling the quartz boat C out of the tube 1 with the bar 4. The inlet of the furnace tube 1 is covered by a quartz cap 2. Furnace gas such as nitrogen is introduced by a gas inlet pipe 1a, flows through the tube 1 and flows out through an outlet pipe 1b.

The furnace tube 1 has heaters 3, shown by chain lines in Fig. 1, disposed outside the furnace tube wall, and is surrounded by a layer of heat insulation material (not shown) such as alumina. A temperature equalizing tube (not shown) of high thermal conductivity ceramic is arranged outside the tube 1 to obtain a uniform axial temperature distribution. With a horizontal furnace of this type, the generation of particulates is inevitable during loading and unloading of wafers as described above. In addition, sticking tends to occur between the quartz tube 1 and quartz boat C in a treatment at high temperature such as approximately 1100°C.

In order to eliminate the generation of particulates as described above, a suspension cantilever loading system is proposed, wherein wafers stacked in baskets are sustained (suspended) inside the furnace tube during all the stages of a heating process: loading, unloading and heat processing. With this system, the wafers, baskets and suspension means never touch the inner wall of the furnace tube, eliminating the generation of particulates.

Fig. 2 is a cross-sectional view of a proposed horizontal furnace apparatus having a suspension cantilever loading system, taken along the axis of the furnace tube, illustrating schematically the structure of the furnace.

For loading wafers A into, or unloading them from, the horizontal furnace, a suspension cantilever 14, carrying baskets B stacked with wafers A, is pushed forward into or pulled out from the center of the furnace tube 1 by a cantilever drive mechanism 15. The upper portion of the cantilever 14 has a boat-like shape suitable for accommodating the baskets B. A cap 12 of the furnace tube 1 has a special opening 12a allowing the passage of a supporting portion of the cantilever.

Fig. 3 is a perspective view of a suspension cantilever system of the horizontal furnace apparatus of Fig. 2. Automatically controlling the operation of the cantilever drive mechanism 15, the loading and unloading of the wafers A can be performed according to a predetermined schedule to reduce undesirable thermal shock to the wafers, which might cause damage to the wafers. Although contact-free loading and unloading with regard to the inner wall of the tube 1 can be completely realised by the above suspension cantilever system, a problem of deformation of the cantilever 14 arises during high temperature heat treatment. In order to minimize deformation of the suspension cantilever 14, a few supports of heat-resistive material such as pure alumina ($Al_2O_3$) or high-grade silicon carbide are used. The supports are sheathed with pure fused quartz so as to be easily cleaned. However, there is a limit to the strength of these materials at high temperature.

To overcome the problem of high temperature deformation, a "soft-landing", that is, descending vertically without any shock, of the baskets B onto the inner wall of the tube 1 during the heat processing can be effected by controlling the cantilever driver 15. After soft-landing of the baskets B, the cantilever 14 is retracted from the furnace tube 1 so as not to be exposed to heating. However, this requires a more complicated mechanism for the driver 15, and essentially contact between the baskets B and the inner wall of the furnace tube 1 still generates particulates.

According to the present invention there is provided horizontal furnace apparatus, comprising a furnace tube, heater means and suspension cantilever means movable in directions parallel to the longitudinal axis of the furnace tube,

the suspension cantilever means comprising an accommodating portion, for accommodating workpieces to be heat treated, a supporting portion, and a connecting portion connecting said accommodating portion and said supporting portion,

the furnace tube comprising

a heating chamber or zone, with the heater means arranged for heating that chamber or zone, for receiving the accommodating portion of the suspension cantilever means, with workpieces to be heat treated, and

a further chamber or zone, extending longitudinally alongside the heating chamber or zone, for receiving the supporting portion of the suspension cantilever means,

the furnace tube allowing passage of the suspension cantilever means for loading, heat processing and unloading of workpieces accommodated on the suspension cantilever means, resulting in the supporting portion of the suspension cantilever means being kept at a lower temperature than the temperature of the heating chamber or zone during a heating process.

An embodiment of the present invention provides horizontal furnace apparatus for example for semiconductor fabrication processes, being capable of or more nearly capable of dust-free or particulates-free operation during loading, unloading and heat processing of workpieces such as semiconductor wafers.

An embodiment of the present invention provides a high temperature horizontal furnace apparatus having a suspension cantilever which suspends workpieces, such as wafers, in a furnace tube during all stages of the process: loading, unloading and processing of the workpieces.

An embodiment of the present invention provides horizontal furnace apparatus having a suspension cantilever system for loading and unloading of wafers, with a cantilever so structured as to prevent or more nearly prevent deformation of the cantilever during high temperature heat treatment of workpieces.

To eliminate the above-mentioned drawbacks of a suspension cantilever system as previously employed, a suspension cantilever in accordance with an embodiment of the present invention comprises a boat-like portion for accommodating workpieces, such as wafers, which is to be exposed to a high temperature during heat processing of the workpieces in the horizontal furnace in accordance with the embodiment, and a rigid supporting rod which during heat processing is positioned in a space of a relatively lower temperature provided in the furnace, so that it retains high rigidity during heat processing. The boat-like portion for accommodating thereon workpieces, e.g. wafers placed in baskets, is supported by the rigid supporting rod for example through stays (a connecting portion of the cantilever) connecting the boat-like portion and the supporting rod. The whole cantilever is made of quartz. For heat processing workpieces, the suspension cantilever is driven to move forward and backward (into and out of the furnace) by a drive mechanism following a predetermined schedule. The horizontal furnace apparatus of the embodiment has a furnace tube having a cross-sectional profile such as to allow the passage of the suspension cantilever. The furnace tube comprises a heating room for heating the workpieces (e.g. wafers) and the boat-like portion, heated by heaters embedded outside the heating room of furnace tube; a supporting room for the supporting rod which is kept at relatively lower temperatures, suitable to maintain the strength of the material of the supporting rod; and a connecting room connecting the heating and supporting rooms over the full length in the axial direction of the heating and supporting rooms, so as to allow the passage of the stays of the cantilever. Usually, the heating room, the connecting room and the supporting room are positioned vertically one below another in the recited order.

Reference is made, by way of example, to the accompanying drawings, in which:-

Fig. 1 is a cross-sectional view of a previously proposed horizontal furnace, taken along the axis of the furnace tube, illustrating schematically the structure of the furnace tube with wafers loaded therein using a quartz boat,

Fig. 2 is a cross-sectional view of a proposed horizontal furnace, taken along the axis of the furnace tube, illustrating schematically the structure of the furnace tube, with wafers loaded therein, using a suspension cantilever loading system,

Fig. 3 is a perspective view illustrating the structure of a suspension cantilever as employed with the furnace of Fig. 2,

Fig. 4 is a schematic perspective view illustrating the structure of an embodiment of the present invention, primarily illustrating a suspension cantilever thereof, Fig. 5(a) is a cross-sectional view of an embodiment of the present invention, taken along the axis of the furnace tube thereof,

Fig. 5(b) is a cross-sectional view of the furnace of Fig. 5(a) taken perpendicularly of the furnace tube axis, illustrating structure and loading of the furnace,

Fig. 6 is a perspective view illustrating a suspension cantilever of another embodiment of the present invention, which cantilever has a combined supporting and connecting portion, and

Fig. 7 is a cross-sectional view illustrating a furnace tube of the embodiment of the present invention which employs the suspension cantilever of Fig. 6.

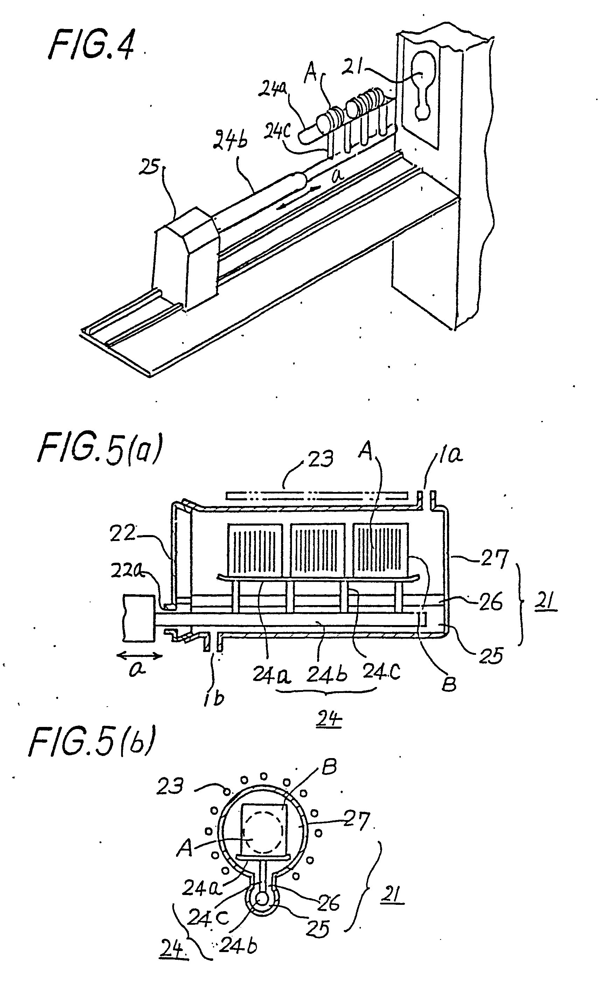

For horizontal furnace apparatus embodying the present invention, a suspension cantilever differing from that of Figs. 2 and 3 is employed. The suspension cantilever of the embodiment is shown in the perspective view of Fig. 4. It comprises an accommodating portion 24a, a supporting portion 24b and connecting portion 24c. The whole cantilever is of quartz. However, other materials such as alumina or silicon nitride may be employed for the supporting portion to provide the cantilever with greater strength. The accommodating portion has a boat-like shape, a rectangular tray having a straight generatrix in a longitudinal direction thereof, and a circular arc cross-section in the perpendicular direction, suitable to accommodate workpieces (for instance suitable to accommodate baskets B containing semiconductor wafers A). The supporting portion 24b is a rigid supporting rod suspended by a suspension cantilever driver 25. The accommodating portion 24a and the supporting rod 24b are connected to each other by the connecting portion 24c, which has a stay structure as shown in Fig. 4. Center planes of the three portions 24a, 24b and 24c are essentially in the same vertical plane.

In accord with the suspension cantilever 24 as described above, an embodiment of the invention employs a horizontal furnace having a cross-sectional profile which permits passage of the suspension cantilever into and out of the furnace. Fig. 5(a) is as schematic cross-sectional view taken along the axis of the furnace tube of a horizontal furnace in accordance with an embodiment of the present invention, and Fig. 5(b) is a schematic cross-sectional view taken perpendicularly of the axis of the horizontal furnace tube. The furnace tube 21 of the horizontal furnace comprises a heating chamber or zone 27 and a support chamber or zone 25 arranged in parallel to one another. The heating chamber or zone 27 is located above the support chamber or zone 25. These chambers are connected by a connecting chamber of zone 26 along the full axial length of the chambers. The heating chamber 27 is heated by heaters 23, whose elements are arranged longitudinally on the exterior of the heating chamber 27. The support chamber 25 has relatively small diameter, as seen in Fig. 5(b), sufficient to allow the supporting rod 24b to move in axial directions thereof without contacting internal walls bounding the chamber 25. The support chamber 25 has no heating means, so as to be kept at a lower temperature than the heating chamber 27 during a heating operation. The cross-sectional profile of the connecting zone 26 is roughly a rectangle, allowing the passage of the stays 24c of the suspension cantilever 24. Thus, the total profile of the cross-section of the tube of the horizontal furnace in accordance with the embodiment of the present invention is a rather complicated one as shown in Fig. 5(b), but the strength of the suspension cantilever 24 is remarkably increased because it is substantially subjected only to a lower temperature in a heating operation, resulting in reduction of elastic deformation and non-detectable permanent deformation (creeping) of the cantilever after repeated operations at high temperature.

To investigate the increased high temperature strength of the cantilever, an experiment was conducted, and the results obtained by the inventor will be described. The cantilever tested was of quartz, on which six baskets, stacked each with 25 6-inch wafers, were loaded. Heat treatment was performed at 1250°C (in the heating chamber) for 10 hours. The cantilever is suspended completely free from contact with internal wall surfaces of the furnace tube. The temperature of the supporting chamber was approximately 700°C. After ten such heat treatments, permanent deformation of the cantilever was not observed. Neither was contact observed between the cantilever and the furnace tube internal wall surfaces by the naked eye. Elastic deformation measured at the end of the cantilever, before and after the experiment, remained almost the same. Furthermore, after the heat treatments, residual particulates on the wafers were carefully checked using a magnifier of low magnification, and satisfactory results were obtained.

In the above experiments, wafers were loaded as the load weight, but it will be appreciated that the load placed in the furnace is not limited to wafers.

In accordance with embodiments of the invention, the cross-sectional profile of the furnace tube is not confined to that shown in Fig. 5(b). Any furnace tube profile can be used which permits the passage of a cantilever in accordance with an embodiment of the invention without contact between the cantilever and the furnace tube wall, and restricts heat transfer from a heating chamber or zone to a support chamber or zone by radiation and convection of furnace gas so that the temperature of the support chamber or zone is reduced. Further, the relative positional arrangement of the heating chamber or zone and the supporting chamber or zone is not confined to the "vertical" arrangement as shown in Figs. 5(a) and (b). Other relative positional arrangements of the two chambers or zones, such as a horizontal arrangement, are possible. However, the vertical arrangement is most suitable to maintain the support chamber or zone at a low temperature, because there occurs no upward heat convection by flow of furnace gas, and no bending moment around its longitudinal axis is applied to the connecting portion of the cantilever.

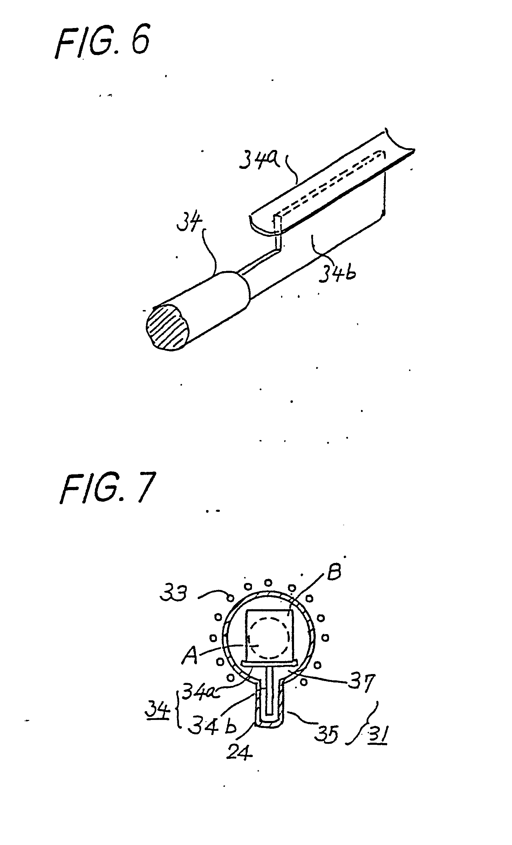

Fig. 6 is a perspective view of a suspension cantilever 34, in accordance with another embodiment of the present invention, which can be considered as a modification of the cantilever 24 of Fig. 4, wherein the supporting portion 24b and connecting portion 24c are replaced by a combined supporting plate 34b which supports an accommodating portion 34a. Fig. 7 is a cross-sectional view of the furnace tube of a furnace employed with the cantilever of Fig. 6, in accordance with an embodiment of the present invention. In accordance with the suspension cantilever 34, the furnace tube 31 has a heating chamber or zone 37, and a combined support-connecting chamber or zone 35 of approximately rectangular cross-section. The overall cross-section of the furnace tube 31 is rather simpler than that of the furnace tube of Figs. 5.

In horizontal furnace apparatus embodying the present invention a horizontal furnace is provided which has a longitudinally extending main heating chamber or zone, into which workpieces are received for heat processing, which is provided with heating means for achieving a desired heat processing temperature, and a further chamber or zone, extending longitudinally alongside and in communication with the main heating chamber or zone, which is not provided with heating means and in which a lower temperature is achieved. The suspension cantilever has an accommodating portion, for carrying workpieces for heat processing and which, for heat processing, is received into the main heating chamber or zone from one longitudinal end of the main zone, and a further portion which, for heat processing, is received into the further chamber or zone from one longitudinal end of the further zone, so that the further portion is subject to the lower temperature.

The further portion of the cantilever provides a supporting part of the cantilever and a connecting part, connecting the supporting part to the accommodating portion.

The longitudinal axis of the accommodating portion is transversely separated from that of a supporting part of the cantilever, with the connecting part joining the accommodating portion and the supporting part together. The connecting part may be formed integrally with the supporting part, as in Fig. 6, or they may be distinct parts, as in Figs. 5.

## Claims

1. Horizontal furnace apparatus, comprising a furnace tube, heater means and suspension cantilever means movable in directions parallel to the longitudinal axis of the furnace tube,

the suspension cantilever means comprising an accommodating portion, for accommodating workpieces to be heat treated, a supporting portion, and a connecting portion connecting said accommodating portion and said supporting portion,

the furnace tube comprising

a heating chamber or zone, with the heater means arranged for heating that chamber or zone, for receiving the accommodating portion of the suspension cantilever means, with workpieces to be heat treated, and

a further chamber or zone, extending longitudinally alongside the heating chamber or zone, for receiving the supporting portion of the suspension cantilever means,

the furnace tube allowing passage of the suspension cantilever means for loading, heat processing and unloading of workpieces accommodated on the suspension cantilever means, resulting in the supporting portion of the suspension cantilever means being kept at a lower temperature than the temperature of the heating chamber or zone during a heating process.

2. Apparatus as claimed in claim 1, wherein the heating chamber or zone and the further chamber or zone are connected along their lengths by a connecting chamber or zone, having a cross-sectional profile in accordance with the shape of the connecting portion of said suspension cantilever means, so that passage of the suspension cantilever means into the furnace tube is permitted during loading and unloading of workpieces into the furnace tube.

3. Apparatus as claimed in claim 1 or 2, wherein the furnace tube is of quartz.

4. Apparatus as claimed in any preceding claim, wherein the heater means comprises a plurality of heater elements which are arranged longitudinally and externally of the furnace tube outside only the heating chamber or zone of the furnace tube.

5. Apparatus as claimed in any one of claims 1 to 4, wherein the connection portion and the supporting portion of the suspension cantilever means are integrally formed.

## Patentansprüche

1. Horizontale Heizvorrichtung, mit einem Heizrohr, Heizeinrichtungen und einer Hängefreiträgereinrichtung, die in Richtung parallel zu der Längsachse des Heizrohres bewegbar ist,

bei welcher die Hängefreiträgereinrichtung einen Aufnahmeabschnitt zur Aufnahme von Werkstücken, die wärmebehandelt werden sollen, und einen Tragabschnitt, und einen Verbindungsabschnitt, der den Aufnahmeabschnitt und den genannten Tragabschnitt verbindet, aufweist,

wobei das Heizrohr umfaßt

eine Heizkammer oder -zone, mit der Heizeinrichtung, die zum Heizen jener Kammer oder Zone angeordnet ist, zum Empfang des Aufnahmeabschnitts der Hängefreiträgereinrichtung, mit den Werkstücken, die wärmebehandelt werden sollen, und

einer weiteren Kammer oder Zone, die sich in Längsrichtung längs der Heizkammer oder -zone erstreckt, zum Empfang des Tragabschnitts der Hängefreiträgereinrichtung,

wobei das Heizrohr den Durchgang der Hängefreiträgereinrichtung zum Laden, Wärmebehandeln und Entladen der Werkstücke, die auf der Hängefreiträgereinrichtung aufgenommen sind, umfaßt, was dazu führt, daß der Tragabschnitt der Hängefreiträgereinrichtung während des Heizprozesses auf einer niedrigeren Temperatur als die Temperatur der Heizkammer oder -zone gehalten wird.

2. Vorrichtung nach Anspruch 1, bei der die Heizkammer oder -zone und die weitere Kammer oder Zone längs ihren Längen durch eine Verbindungskammer oder -zone verbunden sind, die ein Querschnittsprofil in Übereinstimmung mit der Form des Verbindungsabschnitts der genannten Hängefreiträgereinrichtung aufweist, so daß der Durchgang der Hängefreiträgereinrichtung in das Heizrohr beim Laden und Entladen der Werkstücke in das Heizrohr zugelassen wird.

3. Vorrichtung nach Anspruch 1 oder 2, bei der das Heizrohr aus Quarz besteht.

4. Vorrichtung nach einem der vorhergehenden Ansprüche, bei der die Heizeinrichtung eine Vielzahl von Heizelementen umfaßt, die in Längsrichtung und außerhalb des Heizrohrs, lediglich außerhalb der Heizkammer oder -zone des Heizrohres, angeordnet sind.

5. Vorrichtung nach einem der Ansprüche 1 bis 4, bei der der Verbindungsabschnitt und der Tragabschnitt der Hängefreiträgereinrichtung einstückig gebildet sind.

## Revendications

1. Appareil à four horizontal, comprenant un tube de four, un dispositif de chauffage et un dispositif de suspension à bras en porte-à-faux mobile en direction parallèle à l'axe longitudinal du tube du four,

le dispositif de suspension à bras en porte-à-faux comprenant une partie de logement destinée à supporter des pièces qui doivent être traitées thermiquement, une partie de support et une partie de connexion reliant la partie de logement à la partie de support,

le tube du four comprenant

une chambre ou zone de chauffage, le dispositif de chauffage étant destiné à chauffer cette chambre ou zone, cette dernière étant destinée à loger la partie de logement du dispositif de suspension à bras en porte-à-faux, avec les pièces qui doivent être traitées thermiquement, et

une chambre ou zone supplémentaire, placée longitudinalement le long de la chambre ou zone de chauffage et destinée à loger la partie de support du dispositif de suspension à bras en porte-à-faux,

le tube du four permettant le passage du dispositif de suspension à bras en porte-à-faux lors du chargement, du traitement thermique et du déchargement des pièces placées sur le dispositif de suspension à bras en porte-à-faux, si bien que la partie de support du dispositif de suspension à bras en porte-à-faux est maintenue à une température inférieure à celle qui règne dans la chambre ou zone de chauffage pendant l'opération de chauffage.

2. Appareil selon la revendication 1, dans lequel la chambre ou zone de chauffage et la chambre ou zone supplémentaire sont reliées suivant leur longueur par une chambre ou zone de connexion, ayant un profil en coupe correspondant à la configuration de la partie de connexion du dispositif de suspension à bras en porte-à-faux, si bien que le passage du dispositif de suspension à bras en porte-à-faux dans le tube du four est possible pendant le chargement des pièces dans le tube du four et leur déchargement.

3. Appareil selon la revendication 1 ou 2, dans lequel le tube du four est formé de quartz.

4. Appareil selon l'une quelconque des revendications précédentes, dans lequel le dispositif de chauffage comporte plusieurs éléments de chauffage disposés longitudinalement à l'extérieur du tube du four, à l'extérieur uniquement de la chambre ou zone de chauffage du tube du four.

5. Appareil selon l'une quelconque des revendications 1 à 4, dans lequel la partie de connexion et la partie de support du dispositif de suspension à bras en porte-à-faux sont réalisées en une seule pièce.

EP 0 164 892 B1

FIG.1

FIG.2

FIG.3

1

# FIG.4

# FIG.5(a)

# FIG.5(b)

FIG. 6

FIG. 7